# FASCICULE DE BREVET EUROPEEN

(11) **EP 2 753 732 B1**
(45) Date de publication et mention de la délivrance du brevet: **16.12.2015**
(21) Numéro de dépôt: 12762326.2
(22) Date de dépôt: 03.09.2012
(51) Int. Cl.: C30B 11/00, C30B 11/14, C30B 29/06

(54) **DISPOSITIF DE FABRICATION DE MATÉRIAU CRISTALLIN À PARTIR D'UN CREUSET À RÉSISTANCE THERMIQUE NON UNIFORME**
VORRICHTUNG ZUR HERSTELLUNG EINES KRISTALLINEN MATERIALS AUS EINEM SCHMELZTIEGEL MIT UNGLEICHFÖRMIGER WÄRMEBESTÄNDIGKEIT
DEVICE FOR MANUFACTURING A CRYSTALLINE MATERIAL FROM A CRUCIBLE HAVING NON-UNIFORM HEAT RESISTANCE

(30) Priorité: 05.09.2011 FR 1102690
(43) Date de publication de la demande: 16.07.2014
(73) Titulaire: Commissariat à l'Énergie Atomique et aux Énergies Alternatives, 75015 Paris (FR)
(72) Inventeur: COUSTIER, Fabrice, F-73000 Chambéry (FR); CAMEL, Denis, F-73000 Chambéry (FR); JOUINI, Anis, F-73000 Chambéry (FR); PIHAN, Etienne, F-73290 La Motte Servolex (FR)
(74) Mandataire: Talbot, Alexandre
(86) Numéro de dépôt international: PCT/FR2012/000348
(87) Numéro de publication internationale: WO 2013/034819

(56) Documents cités:
- WO-A1-2010/005705
- WO-A2-2011/009062
- CN-A- 101 935 869
- CN-A- 101 979 718
- DE-A1-102010 000 687
- DE-A1-102010 014 724
- DE-A1-102010 030 124
- FR-A1- 2 853 913
- FR-A1- 2 935 618
- JP-A- 2000 327 474
- US-A1- 2011 180 229

## Description

### Domaine technique de l'invention

L'invention concerne un dispositif formant creuset pour la fabrication de matériau cristallin par cristallisation dirigée muni d'un fond et d'au moins une paroi latérale.

### État de la technique

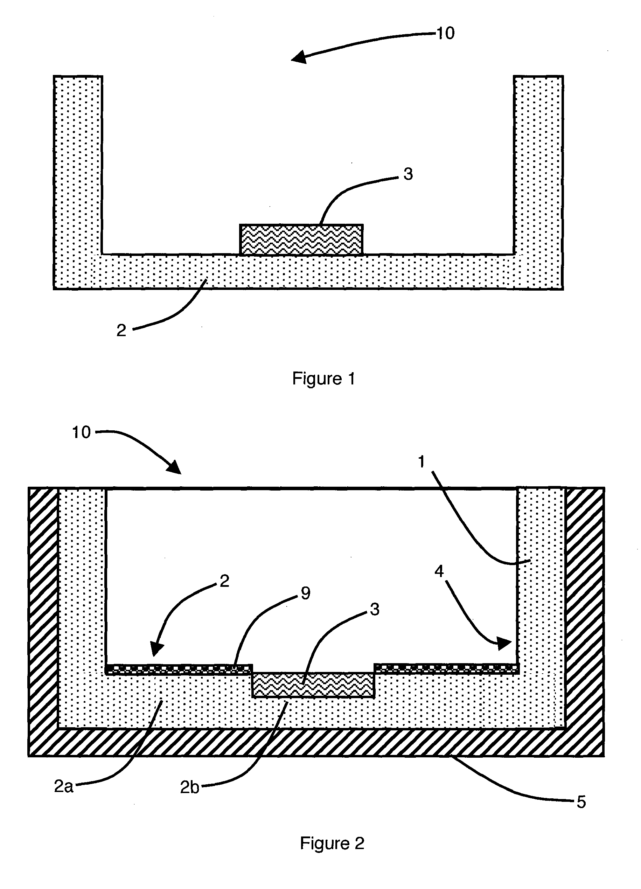

Le silicium utilisé dans l'industrie photovoltaïque est majoritairement du silicium cristallisé de structure multi-cristalline, c'est-à-dire des grains monocristallins sans orientation fixe les uns par rapport aux autres et entourés par des joints de grains. La croissance de ce type de matériau est réalisée à l'intérieur d'un creuset dans un four de cristallisation de type Bridgman. Comme cela est illustré à la figure 1, le creuset 10 présente un fond 2 partiellement recouvert par un germe 3.

Afin d'améliorer l'orientation des grains dans le matériau obtenu, un germe, c'est-à-dire un noyau de croissance, est déposé dans le fond du creuset. Une charge de silicium est ensuite déposée dans le creuset puis fondue en prenant soin de ne pas faire fondre le germe intégralement. Ensuite, la solidification du bain liquide est réalisée à partir du germe qui initie la cristallisation de manière définie à partir de son orientation cristalline de surface.

Cette technique, dite de reprise sur germe, permet de mieux contrôler les conditions de croissance du silicium, mais il existe une contrainte supplémentaire liée à la présence du germe dans le creuset. Le gradient thermique à l'intérieur du creuset doit être parfaitement maîtrisé de manière à éviter la dissolution totale du germe.

La solidification du matériau cristallin à partir du germe ne peut donc avoir lieu que si le bain fondu est en contact du germe qui est resté au moins en partie à l'état solide. Cette disposition particulière impose des contraintes importantes sur le gradient thermique à l'intérieur du creuset et principalement au niveau du germe.

Dans le document WO 2010/005705, un échangeur thermique est disposé uniquement sous le germe à l'intérieur du contre-creuset référencé 70. Cette architecture particulière réalise le refroidissement du bain liquide à travers le germe de façon à réduire les risques de fusion du germe. Cependant, cette architecture entraîne également la création d'isothermes qui ne sont pas parallèles au fond du creuset ce qui est préjudiciable aux performances électriques du matériau cristallin obtenu.

Le document US2011/0180229 décrit un creuset ayant un fond composite définissant des zones avec des propriétés thermiques différentes pour le transfert de la chaleur. Un enseignement semblable est présent dans les documents CN101979718 et CN 101935869 qui décrivent un creuset avec un fond muni de plusieurs échancrures.

Dans le document FR2853913 on divulgue un creuset ayant des parois latérales et un fond présentant des propriétés de transfert thermique très différentes.

### Objet de l'invention

L'objet de l'invention a pour but de fournir un dispositif formant creuset qui résout au moins en partie les inconvénients cités précédemment.

On tend à atteindre cet objectif au moyen d'un dispositif selon les revendications annexées.

L'invention a également pour objet de fournir un procédé de fabrication du creuset.

On tend à atteindre cet objectif au moyen d'un procédé selon les revendications annexées:
L'invention a également pour objet de fournir un procédé de fabrication de matériau cristallin qui permette de gérer plus facilement la croissance à partir d'un germe présent dans le fond d'un creuset.

On tend à atteindre cet objectif au moyen d'un procédé selon les revendications annexées.

### Description sommaire des dessins

D'autres avantages et caractéristiques ressortiront plus clairement de la description qui va suivre des modes particuliers de réalisation de l'invention donnés à titre d'exemples non limitatifs et représentés aux dessins annexés, dans lesquels :
- la figure 1, déjà décrite, représente une vue schématique, en coupe transversale, d'un creuset comportant un germe, selon un exemple de l'art antérieur ;
- les figures 2 à 5 représentent de manière schématique, en coupe transversale, différentes variantes de réalisation d'un creuset selon un premier mode de réalisation de l'invention comportant un germe ;
- les figures 6 et 7 représentent, de manière schématique, en vue de dessus et en perspective, un creuset muni de cavités circulaires formées dans la face interne du fond du creuset ;
- les figures 8 à 11 représentent, de manière schématique, en vue de dessus et en perspective, un creuset muni de cavités longitudinales formées dans la face interne du fond du creuset, la section des cavités étant rectangulaire ou triangulaire ;
- la figure 12 représentent, de manière schématique, en perspective, un contre-creuset muni de saillies longitudinales destinées à collaborer avec les cavités longitudinales formées dans la face externe du fond du creuset de la figure 11 ;
- la figure 13 représente de manière schématique, en coupe transversale, un creuset selon un deuxième mode de réalisation de l'invention ;
- la figure 14 représente de manière schématique, en coupe transversale, un dispositif de solidification selon l'invention muni d'un creuset et d'un germe,
- les figures 15 et 16 représentent deux étapes du procédé de formation de la couche anti-adhérente dans le fond du creuset.

### Description d'un mode préférentiel de l'invention

Le dispositif formant creuset 10, par la suite appelé creuset, selon l'invention comporte un fond 2 et au moins une paroi latérale 4. La forme du creuset 10 est quelconque. A titre d'exemple, la section, c'est-à-dire la forme dessinée par le fond du creuset peut être carrée, rectangulaire ou cylindrique.

Dans le cas d'un creuset de section carrée ou rectangulaire, le creuset comporte plusieurs parois latérales 4 reliées deux à deux de manière à délimiter, avec le fond 2, l'espace intérieur du creuset destiné à recevoir le matériau lors de sa solidification par cristallisation dirigée. Dans le cas d'un creuset à section cylindrique, par exemple cylindrique de révolution, le creuset 10 comporte un seule paroi latérale 4 qui s'étend suivant la périphérie du fond de manière à délimiter, avec le fond 2, l'espace intérieur du creuset. Les parois latérales 4 sont perpendiculaires au fond 2 du creuset 10 ou sensiblement perpendiculaires au fond 2.

Le fond 2 et la ou les parois latérales 4 du creuset 10 font partie d'une pièce étanche 1 du creuset 10.

La pièce étanche 1 est réalisée dans un matériau résistant aux fortes températures subies lors des phases de fusion et de solidification. De manière préférentielle, la pièce étanche 1 du creuset 10 est réalisée en silice. La pièce étanche 1 peut également être réalisée en graphite ou en matériau composite comportant un mélange de résine et de fibres de renfort, tels que des fibres de carbone.

Le creuset 10 est de préférence monobloc afin de renforcer le maintien mécanique, mais il peut également comprendre en plus de la pièce étanche d'autres éléments rapportés.

Le creuset 10, au moyen de sa pièce étanche 1, assure une fonction d'étanchéité vis-à-vis du matériau fondu, c'est-à-dire que le fond 2 et les parois latérales 4 ne permettent pas la sortie du matériau fondu hors du creuset.

Le fond 2 du creuset 10 présente une première portion 2a avec une première valeur de résistance thermique et une deuxième portion 2b avec une deuxième valeur de résistance thermique qui est inférieure à la première valeur. Par résistance thermique, on entend la capacité du fond du creuset à limiter le transfert de chaleur entre les faces interne et externe. La deuxième portion 2b est destinée à recevoir un germe en un second matériau cristallin pour aider à la fabrication du matériau cristallin. Le second matériau cristallin peut être identique ou différent du matériau à solidifier.

Cette particularité du creuset 10 permet d'extraire plus facilement de la chaleur à travers la deuxième portion 2b qu'à travers la première portion 2a. La forme de la deuxième portion est quelconque, par exemple carrée, ronde, ou rectangulaire. La valeur de la résistance thermique est mesurée entre la face interne du creuset et la face externe du creuset dans une direction plus ou moins perpendiculaire aux faces interne et externe.

Par ailleurs, selon l'invention, la pièce étanche 1 comporte au moins une échancrure qui participe à définir les première et deuxième portions 2a et 2b. La ou les échancrures sont disposées au niveau du fond de la pièce étanche 1 et les échancrures peuvent être situées au niveau de la face interne ou au niveau de la face externe de la pièce étanche. La face interne de la pièce étanche 1 est celle qui est destinée à recevoir le matériau à solidifier.

Le fond 2 et la paroi latérale 4 du dispositif formant creuset sont au moins en partie formés par la pièce étanche 1, de préférence monobloc, de manière encore plus préférentielle monolithique, c'est-à-dire réalisée en un même matériau. Dans le cas d'une intégration monolithique, la pièce étanche 1 forme le creuset 10. Dans le cas d'une intégration monobloc, la pièce étanche 1 est associée à un ou des éléments additionnels pour former le creuset 10.

Selon un premier mode de réalisation préféré, l'échancrure dans le fond 2 de la pièce étanche du creuset 1 définit ou contient la deuxième portion 2b du fond du creuset.

Comme le montre la figure 2, la pièce étanche 1 comprend une échancrure située dans la face interne du fond 2. L'échancrure définit la deuxième portion 2b.

La première portion 2a peut entourer complètement la seconde portion 2b qui est située, ici, sensiblement au centre du fond 2 de la pièce étanche 1, par rapport aux parois latérales 4. La première portion 2a s'étend sur tout le contour de la seconde portion 2b.

Le fond 2 de la pièce étanche 1 peut comporter une première portion 2a formant un anneau, présentant de préférence un axe de symétrie perpendiculaire au fond du creuset, autour de la seconde portion 2b afin de conserver un maximum de symétrie dans les échanges thermiques au sein du creuset.

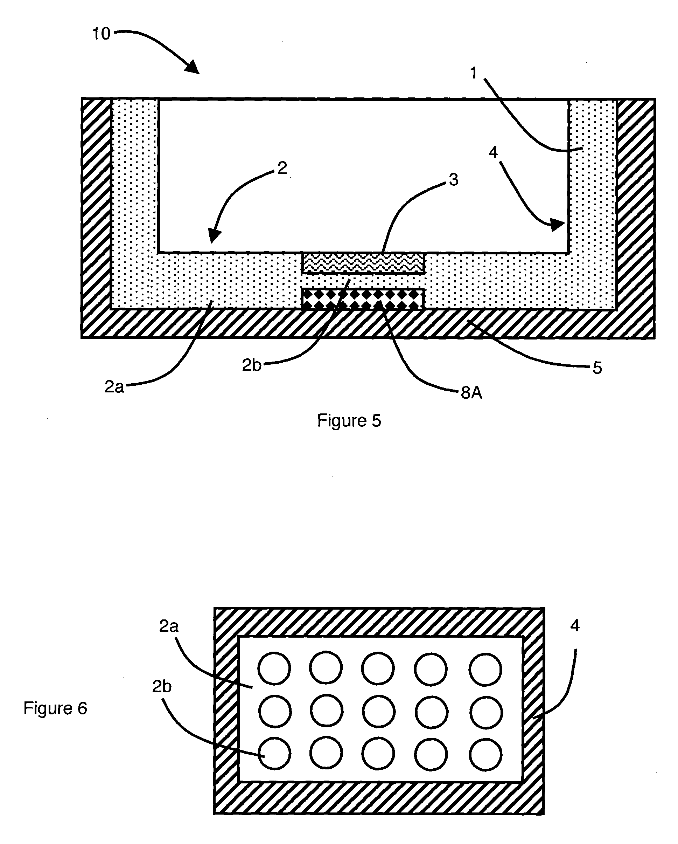

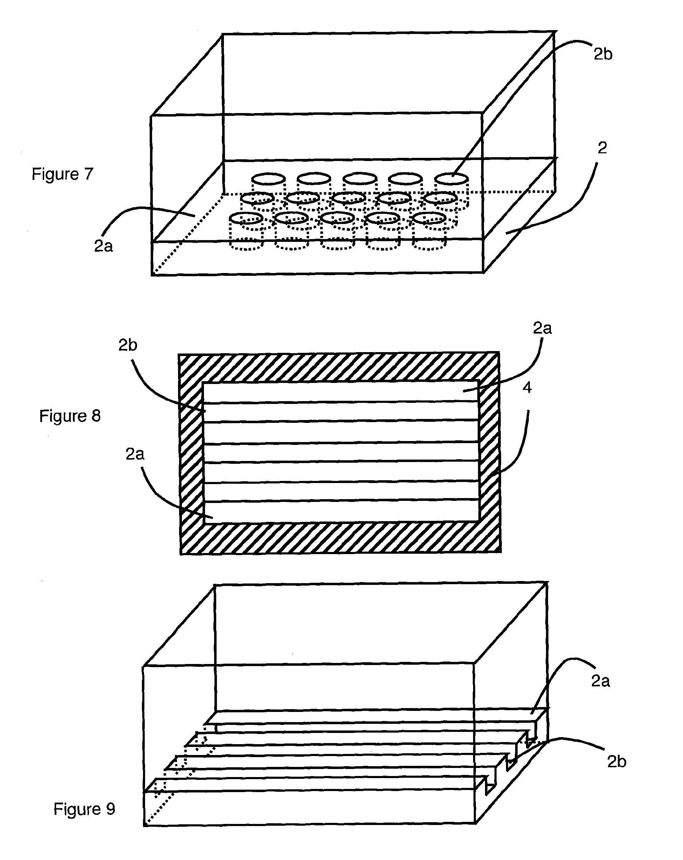

Dans une variante de réalisation, le fond 2 de la pièce étanche 1 comporte une pluralité de premières portions 2a et de secondes portions 2b. A titre d'exemple, le fond 2 comporte une pluralité de secondes portions 2b qui sont toutes entourées par une première portion 2a (figures 6 et 7).

Dans un mode de réalisation préférentiel, les première et seconde portions 2a, 2b relient deux faces latérales du fond 2 du creuset. Les deux faces peuvent être deux faces latérales consécutives ou deux faces latérales opposées. Dans ce cas, la première portion 2a entoure au moins partiellement la deuxième portion 2b, c'est-à-dire que la première portion 2a s'étend sur au moins une partie du contour de la deuxième portion 2b (figures 8 à 11).

Les première et seconde portions présentent avantageusement des axes longitudinaux parallèles. Dans un mode de réalisation encore plus privilégié, il y a une alternance entre les première et deuxième portions dans le fond de la pièce étanche 1.

Lorsque plusieurs deuxièmes portions 2b sont utilisées, il est possible de mélanger les différents modes de réalisation illustrés plus haut dans le fond de la pièce étanche 1.

Comme le montre la figure 2, l'épaisseur de la première portion 2a est supérieure à l'épaisseur de la seconde portion 2b de manière à obtenir une différence de résistance thermique dans le fond 2 de la pièce étanche 1.

Dans le mode de réalisation illustré à la figure 2, la paroi externe du fond 2 de la pièce étanche 1 est plane ce qui permet de répartir la charge imposée par le bain fondu et d'éviter une déformation rapide de la pièce étanche 1 durant son utilisation. L'échancrure, ou zone en dépression, présente au niveau de la face interne du fond 2 de la pièce étanche définit la deuxième portion 2b. L'échancrure est une zone d'épaisseur réduite dans la pièce étanche, tel qu'un évidement ou un trou non débouchant. L'échancrure comporte un fond et au moins une parois latérale.

Cette échancrure est une zone préférentielle pour placer le germe 3 car elle permet une meilleure évacuation de la chaleur provenant du bain de matériau fondu. De manière préférentielle, le germe 3 a des dimensions latérales inférieures à celle de l'échancrure de manière à éviter tout chevauchement qui engendre un jeu de contraintes pouvant briser le germe.

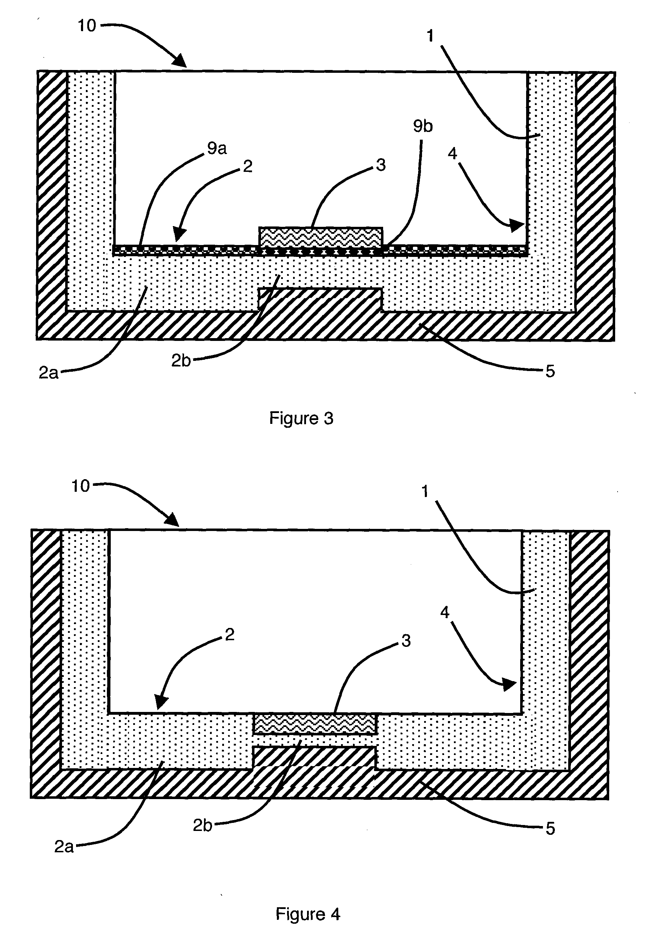

Dans une variante du premier mode de réalisation illustrée à la figure 3, la paroi interne du fond 2 de la pièce étanche 1 est plane ce qui permet de faciliter la mise en oeuvre de la pièce étanche 1. L'échancrure, ou zone en dépression, présente au niveau de la face externe du fond de la pièce étanche 1 définit la deuxième portion 2b. Le germe 3 est placé au moins partiellement au-dessus de la deuxième portion 2b afin de profiter de la meilleure évacuation de la chaleur provenant du bain de matériau fondu. Le germe 3 est en saillie dans le fond de la pièce étanche 1 et il peut s'étendre, de manière préférentielle, au delà de la deuxième portion 2b. L'amincissement du fond de la pièce étanche 1 est réalisé à partir de la face externe ce qui est facile à réaliser et évite de détériorer la face interne qui doit recevoir le matériau à cristalliser.

Dans une autre variante du premier mode de réalisation illustrée sur la figure 4, la seconde portion 2b se traduit par la présence d'échancrures, ou zones en dépression, sur les faces interne et externe du fond 2 de la pièce étanche 1. Ces deux zones en dépression se font face. De manière préférentielle, les deux échancrures ont le même dessin. Cependant, il n'est pas exclu d'avoir un dessin plus grand que l'autre ou un décalage évitant un chevauchement complet de manière à former différentes zones avec des valeurs de résistance intermédiaires.

Il est intéressant de placer un ou plusieurs germes 3 à l'intérieur de l'échancrure de la face interne du fond 2 afin de profiter d'une résistance thermique diminuée et de mieux maîtriser l'orientation cristalline dans le matériau solidifié.

Dans les différents modes de réalisation illustrés plus haut, la pièce étanche 1 forme le creuset 10. De manière préférentielle, la pièce étanche 1 est monolithique, c'est-à-dire qu'elle est réalisée en un seul matériau pour réduire les contraintes de dilatation thermique.

Dans encore une autre variante du premier mode de réalisation illustré à la figure 5, le dispositif formant creuset 10 peut comporter la pièce étanche 1 associée à une pièce 8A supplémentaire. Ainsi, le fond du creuset 10 comprend le fond de la pièce étanche 1 ainsi que la pièce 8A. La face externe du fond de la pièce étanche 1 comporte une échancrure et la pièce 8A supplémentaire est configurée pour se loger dans cette échancrure. Les dimensions de la pièce 8A sont inférieures à celles de l'échancrure de manière à rentrer dans l'échancrure. Le creuset 10 comporte une première portion 2a ayant une première valeur de résistance thermique et une deuxième portion 2b ayant une deuxième valeur de résistance thermique inférieure à la première valeur. L'échancrure participe à définir les deux portions dans le fond du creuset 10, ici la deuxième portion 2b correspond à la zone échancrée.

La pièce 8A supplémentaire est configurée de sorte que la somme de sa résistance thermique avec celle de la pièce étanche 1 dans la deuxième portion 2b, est toujours inférieure à la valeur de résistance thermique de la pièce étanche 1 dans la première portion 2a. La deuxième résistance thermique provient de la mise en série de la pièce étanche 1 avec la pièce 8A au niveau de la deuxième portion 2b. La première résistance thermique est formée par la pièce étanche 1 au niveau de la première portion 2a. La pièce 8A additionnelle est réalisée en un matériau présentant une faible résistivité thermique, inférieure à celle du fond de la pièce étanche 1, par exemple en graphite ou en molybdène dans le cas d'une pièce étanche en silice.

Dans le cas où la pièce 8A présente une surface inférieure à celle de l'échancrure, il est possible de définir deux portions ayant deux valeurs de résistance thermique différentes à l'intérieur de la surface délimitée par l'échancrure. La deuxième portion est définie par la zone de contact avec la pièce 8A et la première portion occupe la surface complémentaire.

Dans un mode de réalisation particulier qui peut être combinable avec les modes de réalisation précédents, il est intéressant de coupler le creuset 10 à un élément de renfort 5 qui assure le rôle de contre-creuset dans le but de réduire la déformation du creuset 1 à haute température. D'une manière générale, lorsque le fond du creuset 10 et le fond du contre-creuset 5 sont réalisés en des matériaux différents, le matériau formant le fond du contre-creuset 5 présente une résistivité thermique inférieure à celle du matériau formant le fond 2 du creuset 10, de manière à assurer un bon transfert thermique du creuset vers l'environnement. Dans un mode de réalisation préférentiel, le contre-creuset 5 est en graphite ou en matériau composite à base de carbone (CFC en anglais pour carbon fiber composite).

Dans un mode de réalisation particulier, le fond du contre-creuset 5 et le fond du creuset 10 présentent des formes complémentaires ce qui permet de répartir les contraintes appliquées par le poids du bain fondu sur le creuset 1 et sur le contre-creuset. Cela permet également de limiter le volume de gaz emprisonné entre le creuset 1 et le contre-creuset 5.

La pièce étanche 1 reçoit le matériau à solidifier et les matériaux utilisés sont choisis de manière à limiter la contamination. Le contre-creuset 5 peut être réalisé dans des matériaux différents et/ou avec une qualité de surface moins importante car le matériau fondu n'est pas en contact direct avec le contre-creuset 5.

Dans le mode de réalisation illustré à la figure 2, la résistance thermique du fond du contre-creuset 5 est constante, car l'épaisseur du matériau formant le fond du contre-creuset 5 est constante. Il existe alors deux valeurs différentes de résistances thermiques dans le fond de l'ensemble formé de la pièce étanche 1 et du contre-creuset 5. La différence de résistance thermique totale est liée à la différence de résistance thermique existant dans la pièce étanche 1, donc dans le creuset 10, comme cela est décrit plus haut.

Dans les modes de réalisation illustrés aux figures 3 et 4, la résistance thermique du fond du contre-creuset 5 n'est pas constante. Il existe deux valeurs différentes de résistance thermique, car l'épaisseur du matériau formant le fond du contre-creuset 5 est variable. Le fond du contre-creuset 5 présente une face externe plane et la variation d'épaisseur permet de remplir l'échancrure présente dans la face externe de la pièce étanche 1. La surépaisseur du contre-creuset 5 permet d'avoir des formes complémentaires pour la pièce étanche 1 et le contre-creuset 5. La surépaisseur définit une deuxième zone 2b' adjacente à la première zone 2a'.

La résistance thermique de la deuxième portion 2b' du contre-creuset 5 est supérieure à la résistance thermique de la première portion 2a' de celui-ci.

Il existe alors deux valeurs différentes de résistances thermiques dans le fond de l'ensemble formé de la pièce étanche 1 et du contre-creuset 5. La différence de résistance thermique totale dans le fond dudit ensemble est liée à la différence de résistance thermique existant dans la pièce étanche 1 et à celle existante dans le contre-creuset 5. Les deux premières zones 2a et 2a' sont montés en série thermique entre la face interne de la pièce étanche 1 et la face externe du contre-creuset 5. Il en va de même des deux deuxièmes zone 2b et 2b'.

Dans ces modes de réalisation, les matériaux formant le fond de la pièce étanche 1 et le fond du contre-creuset 5 et éventuellement la profondeur de l'échancrure sont choisis de manière à ce que la résistance thermique cumulée des deuxièmes zones 2b et 2b' soit inférieure à la résistance thermique cumulée des première zones 2a et 2a'. Plus précisément, le matériau du fond du contre-creuset présente une résistivité inférieure à celle du matériau du fond de la pièce étanche 1. Le creuset comporte un fond avec une première zone 2a ayant une première valeur de résistance thermique et une deuxième zone 2b ayant une deuxième valeur de résistance thermique inférieure à la première valeur. Ces deux zones sont définies au moyen de l'échancrure formée dans la pièce étanche. Le germe 3 est placé face à la deuxième zone afin de profiter d'une meilleure évacuation de la chaleur à travers le creuset et le contre-creuset.

Dans encore une autre variante du premier mode de réalisation illustrée à la figure 5, lorsque la pièce étanche 1 et le contre-creuset 5 n'ont pas des formes complémentaires, il est préférable d'ajouter la pièce additionnelle 8A à l'ensemble. La pièce 8A est configurée de manière à remplir la zone vide située entre le contre-creuset 5 et la pièce étanche 1 et à favoriser l'extraction de chaleur via la deuxième portion du creuset 10. Ainsi, le matériau de la pièce 8A présente une résistivité thermique inférieure à celle du fond de la pièce étanche, et avantageusement inférieure ou égale à celle du fond du contre-creuset 5.

Cette pièce 8A supplémentaire est disposée entre la pièce étanche 1 et le contre-creuset 5 afin de remplir l'échancrure qui existe sur la face externe du fond 2 de la pièce étanche 1 et éventuellement la face interne du fond du contre-creuset 5.

Comme pour les modes de réalisation précédentes, il existe alors deux valeurs différentes de résistances thermiques dans le fond de l'ensemble formé du contre-creuset 5 et du creuset 10. La différence de résistance thermique totale dans le fond dudit ensemble est liée essentiellement à la différence de résistance thermique existant dans le creuset 10 formé de la pièce étanche 1 munie de la pièce additionnelle 8A.

La face interne du contre-creuset 5 peut comporter une échancrure pour faciliter le positionnement de la pièce 8A supplémentaire. La pièce 8A supplémentaire peut également être configurée de sorte que la somme de sa résistance thermique avec la résistance thermique des deuxièmes portions de la pièce étanche 1 et du contre-creuset 5 est inférieure à la somme des résistances thermiques des premières portions de la pièce étanche 1 et du contre-creuset 5 lorsque la pièce 8A s'enfonce dans la pièce étanche 1 et dans le contre-creuset 5 (non représentée).

Ce mode de réalisation permet, par exemple, d'utiliser une pièce étanche 1 munie d'échancrure sur sa face externe et un contre-creuset 5 ayant une face interne plane pour le fond.

Si la pièce 8A supplémentaire s'enfonce dans la pièce étanche 1 et le contre-creuset 5, on prendra soin de choisir le matériau de la pièce 8A de manière à avoir une résistance thermique pour l'empilement pièce étanche/pièce 8A/ contre-creuset au niveau de la seconde portion 2b plus faible que celle du couple pièce étanche/contre-creuset au niveau de la première portion 2a.

La figure 6 représente, en vue de dessus, une pièce étanche 1 munie d'une pluralité de deuxièmes portions 2b formées par des échancrures circulaires sur la face interne. La figure 7 représente, en perspective, le fond d'une pièce étanche 1 munie d'une pluralité de cavités circulaires. Les cavités circulaires sont destinées à recevoir un germe. Les parois latérales 4 sont représentées de manière schématique sans épaisseur pour faciliter la compréhension.

La figure 8 représente, en vue de dessus, un creuset 10 muni d'une pluralité de deuxièmes portions 2b rectangulaires. Les premières et deuxièmes portions 2a et 2b s'étendent d'une paroi latérale à la paroi latérale opposée et définissent dans cet exemple une alternance entre les premières et deuxième portions. Dans l'exemple illustré, les premières portions 2a sont également rectangulaires en vue de dessus.

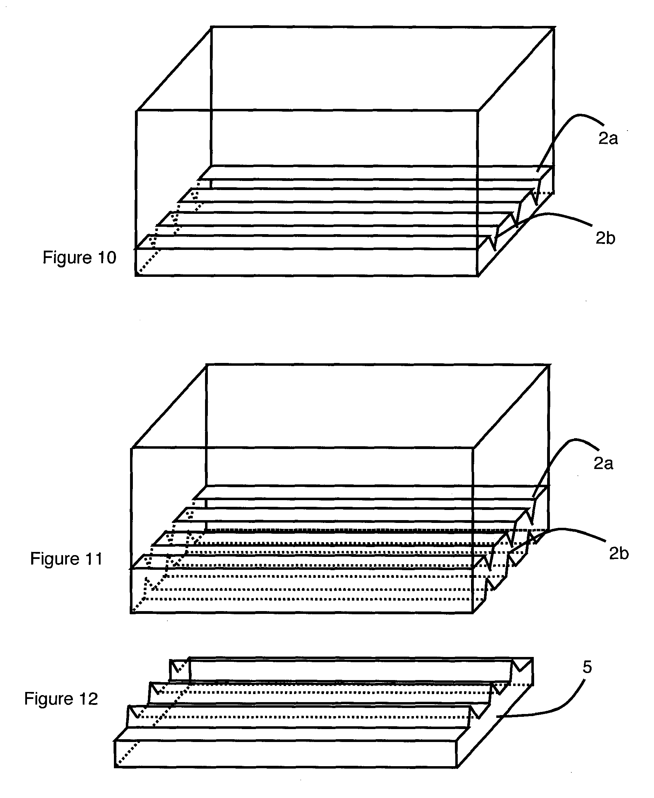

Les figures 9 et 10 représentent en perspective le fond d'un creuset muni d'une pluralité de cavités rectangulaires configurées pour recevoir un germe ayant la forme d'une barre. Les parois latérales sont représentées de manière schématique sans épaisseur. Dans le cas de la figure 9, les cavités ont une section rectangulaire ou carrée afin de recevoir des germes ayant une section de forme complémentaire. Dans le cas de la figure 10, les cavités ont une section triangulaire afin de recevoir préférentiellement des germes ayant également une section triangulaire.

La figure 11 représente un creuset muni des mêmes cavités internes que le creuset de la figure 10. Le creuset comporte en plus des cavités formées sur la face externe du fond 2 du creuset 1. Les cavités de la face externe sont disposées face aux cavités de la face interne, c'est-à-dire immédiatement dessous, de manière à faciliter l'extraction de la chaleur dans les deuxièmes portions 2b.

Comme indiqué plus haut, le contre-creuset 5 peut également présenter des zones en saillies destinées à s'encastrer avec les zones en dépression présentes sur la face externe du fond 2 du creuset 1. La figure 12 illustre, en perspective, un contre-creuset 5 pouvant s'encastrer avec le creuset représenté sur la figure 11.

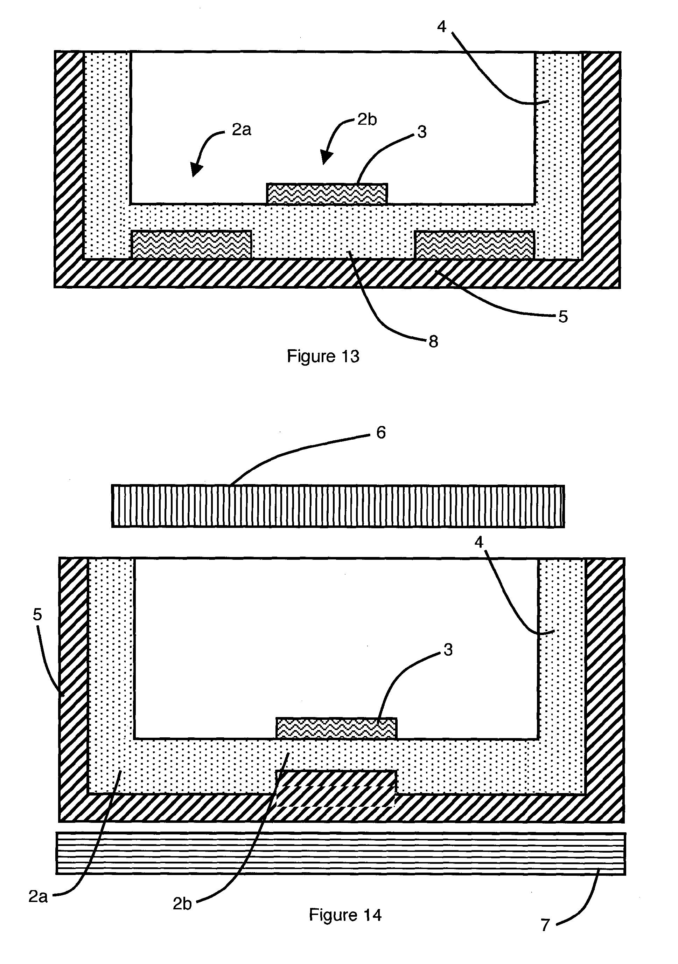

Dans un deuxième mode de réalisation illustré à la figure 13, le dispositif formant creuset 10 comporte la pièce étanche 1 associée à une pièce 8B supplémentaire. La face externe du fond de la pièce étanche 1 comporte une échancrure et la pièce 8B supplémentaire est configurée pour se loger dans cette échancrure. Les dimensions de la pièce 8B sont inférieures à celles de l'échancrure de manière à rentrer dans l'échancrure. Le fond du creuset 10 comporte une première portion 2a ayant une première valeur de résistance thermique et une deuxième portion 2b ayant une deuxième valeur de résistance thermique inférieure à la première valeur. L'échancrure participe à définir les deux portions 2a et 2b dans le fond de la pièce étanche 1.

La pièce 8B supplémentaire est configurée de sorte que la somme de sa résistance thermique avec la résistance thermique de la pièce étanche 1 au niveau de la deuxième portion 2b est supérieure à la valeur de résistance thermique de la pièce étanche 1 au niveau de la première portion 2a. De cette manière, le fond du creuset 10 présente une première portion 2a avec une première valeur de résistance thermique et une deuxième portion 2b avec une deuxième valeur de résistance thermique inférieure à la première valeur. La première résistance thermique du creuset 10 provient de la mise en série, au niveau de la deuxième portion 2b de la pièce étanche 1 avec la pièce 8B. La deuxième résistance thermique du creuset 10 est formée, au niveau de la première portion 2a, par la seule pièce étanche 1.

Dans le deuxième mode de réalisation, la pièce 8B est formée dans un matériau qui est plus isolant thermiquement que le fond de la pièce étanche 1, c'est-à-dire que le matériau de la pièce 8B présente une résistivité thermique plus élevée que celle du matériau du fond de la pièce étanche 1. Dans le deuxième mode de réalisation, l'échancrure de la pièce étanche 1 ne sert plus à définir la deuxième portion 2b du creuset 10 mais la première portion 2a du creuset 10.

Ce deuxième mode de réalisation permet de former une zone à forte résistance thermique au niveau de la portion 2a comportant l'échancrure. Le germe est placé en face de la zone à plus faible résistance thermique, ici hors de la portion 2a faisant face à l'échancrure, au niveau de la seconde portion 2b.

A titre illustratif, dans le cas où le creuset est réalisé en graphite, en SiC, ou en composite de fibre de carbone/SiC, les pièces 8B supplémentaires apportant une isolation thermique dans les échancrures sont alors préférentiellement en fibres de graphite à faible densité, par exemple entre 0,25g/cm³, de manière préférentielle entre 0,14 et 0,20/cm³ pour avoir une différence de résistance thermique notable dans la gamme d'épaisseur des échancrures à remplir. Cependant, d'autres matériaux sont possibles, par exemple, le nitrure de bore, l'alumine, le nitrure de silicium, la zircone yttriée, la zircone, le quartz et la silice.

Dans un mode de réalisation non représenté, le contre-creuset 5 peut également présenter des échancrures qui ne sont pas complémentaires de la face externe du creuset. Ces échancrures peuvent être ensuite remplies par un matériau qui est plus isolant thermiquement que le matériau formant le fond du creuset et/ou le fond du contre-creuset afin de former une zone plus résistante thermiquement.

Les différents modes de réalisation évoqués ci-dessus peuvent être combinés entre eux dans un même creuset ainsi que les différentes variantes décrites.

Dans un mode particulier de réalisation illustré à la figure 2 qui peut être combiné avec les modes de réalisation précédents, le fond 2 de la pièce étanche 1 est partiellement ou complètement recouvert d'une couche anti-adhérente 9. Dans un premier cas de figure, la deuxième portion 2b du fond de la pièce étanche 1 est dépourvue de couche anti-adhérente 9 et la première portion 2a est recouverte par la couche anti-adhérente 9. La localisation particulière de la couche anti-adhérente 9 permet de conserver une meilleure extraction de la chaleur au niveau de la deuxième portion 2b par rapport à la première portion 2a. Dans un second cas de figure, illustré à la figure 3, deux couches anti-adhérentes différentes 9a et 9b sont déposées dans le fond de la pièce étanche 1. La première couche anti-adhérente 9a est déposée dans la première portion 2a alors que la deuxième couche anti-adhérente 9b est déposée dans la deuxième portion 2b. Les caractéristiques thermiques de la première et de la deuxième couches anti-adhérentes sont choisies de manière à accroître la différence de résistance thermique entre les deux portions 2a et 2b. De ce fait, la deuxième couche anti-adhérente 9b a une résistance thermique inférieure à celle de la première couche anti-adhérente 9a. La différence de conductivité thermique entre la première couche anti-adhérente 9a et la deuxième couche anti-adhérente 9b ou entre les zones comprenant la couche anti-adhérente 9 et les zones dépourvues de couche anti-adhérente 9 est avantageusement comprise entre 0,5 et 5W/mK pour une épaisseur de 500µm. Cette différence de conductivité thermique a un effet particulièrement important pour un creuset en graphite qui est très conducteur thermiquement.

En d'autres termes, la première portion 2a est recouverte par une première couche anti-adhérente 9 ayant une première résistance thermique additionnelle et la deuxième portion 2b est éventuellement recouverte par une deuxième couche anti-adhérente 9b ayant une deuxième résistance thermique additionnelle inférieure à la première résistance thermique.

La première couche anti-adhérente 9a peut être plus épaisse que la deuxième couche anti-adhérente 9b. Dans un mode de réalisation particulier, la première couche anti-adhérente 9a est réalisée dans le même matériau que la deuxième couche anti-adhérente 9b.

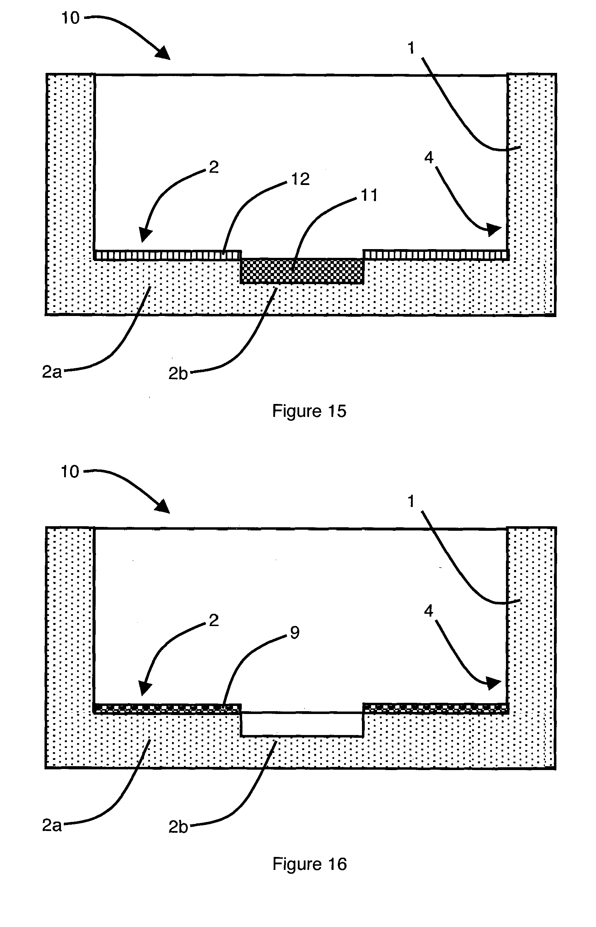

Comme illustré à la figure 15, de manière à former une deuxième portion 2b dépourvue de couche adhérente 9, il est possible d'utiliser un masque 11 qui est appliqué sur la deuxième portion 2b. Dans un mode de réalisation particulier, le masque 11 est formé avant le dépôt du revêtement destiné à former la couche anti-adhérente 9. Le masque est retiré après le dépôt du matériau visant à former la couche anti-adhérente 9, par exemple après l'étape de pulvérisation ou spray. Le masque 11 est enlevé avant l'étape de recuit de formation de la couche anti-adhérente 9. Dans un exemple particulier, le masque 11 est une feuille de papier.

La première phase de dépôt peut être suivie d'une deuxième phase de dépôt d'un matériau destiné à former une couche anti-adhérente. La première phase de dépôt définit un premier motif et la deuxième phase de dépôt peut être un dépôt sur la totalité du fond, c'est-à-dire sur les première et deuxième portions afin de former la première couche anti-adhérente 9a et la seconde couche anti-adhérente 9b ayant une épaisse plus faible. Si le même matériau est déposé dans les deux phases, le même matériau anti-adhésif est présent au dessus des première et deuxième portions 2a et 2b avec des épaisseurs différentes. Si les deux matériaux sont différents, l'épaisseur et la composition entre la première couche anti-adhérente 9a et la deuxième couche anti-adhérente 9b sont différentes.

En d'autres termes, la formation sélective de la couche anti-adhérente ou de la première couche anti-adhérente 9a peut être réalisée de la manière suivante :
- former un masque 11 sur le fond 2 du creuset 10 de manière à définir des zones recouvertes par le masque 11 et des zones découvertes,
- déposer un revêtement 12 destiné à former une couche anti-adhérente 9,
- éliminer le masque 11,
- recuire le revêtement 12 pour former la première couche anti-adhérente 9a ou la couche anti-adhérente 9.

Ce procédé de fabrication est particulièrement facile à mettre en oeuvre pour définir des motifs variés sur les fonds de creuset plans ou texturés.

Eliminer la couche anti-adhérente 9 sous la future position du germe 3 permet de réduire la contamination du germe 3 dans le cas où le creuset 10 est plus pur que la couche anti-adhérente 9.

La couche anti-adhérente 9 est avantageusement une couche poreuse qui n'est pas ou peu infiltrée par le silicium (notamment à l'état fondu) de sorte que le silicium solidifié présente une adhésion faible avec la couche anti-adhérente 9.

A titre d'exemple, la qualité d'anti-adhérence d'une couche anti-adhérente 9 est analysée par le dépôt d'une goutte de silicium sur la couche anti-adhérente 9 et avec l'étude de la variation de son volume dans le temps. Plus la variation de volume de la goutte de silicium est importante et plus le silicium s'est introduit dans la couche anti-adhérente 9. Il en ressort que plus la variation de volume est importante et moins bonnes sont les qualités d'anti-adhérences de la couche 9 étudiée. De manière classique, la couche anti-adhérente 9 étudiée est déposée sur une couche du matériau formant le creuset 10 afin de se rapprocher au maximum des conditions réelles d'utilisation.

Dans un mode de réalisation particulier, la couche anti-adhérente 9 est en nitrure de silicium qui est avantageusement oxydée sur la surface de contact avec la future charge de silicium.

A titre d'exemple, une couche anti-adhérente 9 ayant une épaisseur comprise entre 50µm et 1000µm a donné de bons résultats expérimentaux.

De manière particulièrement avantageuse, la couche anti-adhérente 9 est déposée par spray. Préférentiellement, le dépôt par spray est suivi d'une étape de recuit configurée pour éliminer le solvant accompagnant le matériau formant la couche anti-adhérente, par exemple de l'eau. Ce recuit peut être réalisé par un plateau à une première température supérieure à la température de vaporisation du solvant.

Le dépôt par spray est suivi par un deuxième recuit configuré pour faire réagir le matériau de la couche anti-adhérente 9 de manière à former la couche poreuse. Ce deuxième recuit est avantageusement réalisé à une température supérieure à 875°C. De manière avantageuse, le recuit est réalisé sous un gaz oxydant ce qui permet d'oxyder le matériau formant la couche anti-adhérente 9, par exemple d'oxyder une poudre de nitrure de silicium.

L'ensemble creuset / contre-creuset présente une résistance thermique variable selon que l'on est en face de la première portion 2a du fond du creuset 10 ou de la deuxième portion 2b du fond du creuset 10. Même si le contre-creuset 5 comporte un épaississement en face de la deuxième portion 2b du fond du creuset, la résistance thermique globale du creuset et du contre-creuset au niveau de la première portion 2a est supérieure à celle du creuset et de contre-creuset au niveau de la seconde portion 2b.

Il est particulièrement intéressant de placer la différence de résistance thermique dans le fond 2 du creuset 10 en comparaison du fond du contre-creuset 5 car la différence de résistance thermique entre les différentes portions du fond du creuset peut être plus marquée et donc plus efficace.

Comme pour le creuset 10, le contre-creuset 5 peut présenter des première et deuxième portions avec des résistances thermiques différentes. De manière préférentielle, les première et deuxième portions du creuset 10 et du contre-creuset 5 se font respectivement face.

Dans un mode de réalisation préférentiel qui peut être combiné aux modes précédents, la paroi externe du fond du contre-creuset 5 est plane ce qui améliore la portance du contre-creuset 5 sur son support et la transmission de chaleur par conduction.

Le creuset 10 est avantageusement destiné à être utilisé dans un dispositif de solidification dirigée pour obtenir des lingots de matériau cristallisé. Le dispositif comporte des moyens de génération d'un gradient thermique à l'intérieur du creuset 10. Les moyens de génération du gradient thermique comporte une source de chaleur 6 qui peut être disposée, par exemple, au-dessus du creuset 10 ou sur les côtés du creuset 10. Les moyens de génération du gradient thermique comportent également un extracteur de chaleur 7 qui est disposé sous le creuset 10. Un tel dispositif est illustré à la figure 14 à titre d'exemple.

En modulant la quantité de chaleur émise par la source de chaleur 6 et absorbée par l'extracteur de chaleur 7, il est possible de moduler la température dans le creuset 10 et la forme du gradient thermique à l'intérieur du creuset 10.

Dans un mode de réalisation préférentiel, l'extracteur de chaleur 7 est disposé face aux première 2a et deuxième 2b portions du fond du creuset 10. L'extracteur de chaleur 7 absorbe alors de la chaleur via la première portion 2a du creuset, mais également via la deuxième portion 2b du creuset. Ceci permet de maintenir des isothermes plus planes et plus parallèles au fond du creuset 10. Les grains obtenus sont plus perpendiculaires au fond du creuset que dans l'art antérieur. De manière préférentielle, l'extracteur de chaleur 7 fait face à l'intégralité de la surface du fond du creuset 10 afin d'avoir des isothermes très planes et parallèles au fond du creuset sur tout le creuset.

La résistance thermique de la deuxième portion 2b étant plus faible que la résistance thermique de la première portion 2a, il y a un meilleur refroidissement du fond 2 du creuset 10 dans la deuxième portion 2b. Le matériau à solidifier en contact avec la première portion 2a peut être à l'état liquide alors que le même matériau est resté à l'état solide lorsqu'il est en contact avec la deuxième portion 2b. Il est possible de manière simple et économique de moduler la température du fond du creuset, par exemple avec un seul extracteur de chaleur recouvrant tout le fond du creuset ce qui facilite la gestion du gradient thermique durant la fusion et/ou la solidification.

Cette architecture permet également une plus grande souplesse dans l'étendue des procédés utilisables. Ainsi, il est possible d'utiliser dans le même dispositif de solidification des creusets et contre-creusets conventionnels et des creusets 10 et contre-creusets 5 avec des résistances thermiques variables afin de faciliter la croissance à partir de germes 3. Il est également possible d'associer un creuset 10 modifié avec un contre-creuset 5 conventionnel selon les modes de réalisation envisagés plus haut. De manière préférentiellement, le germe 3 recouvre partiellement le fond de la pièce étanche et de manière encore plus préférentielle les zones à résistances thermiques les plus faible. Cette particularité permet de conserver plus facilement le germe à l'état solide durant tout le procédé de fusion/solidification.

Le matériau à solidifier déposé dans le creuset 10 est, par exemple du silicium, du germanium, de l'arséniure de gallium... Le germe 3 utilisé dans le fond 2 du creuset 10 peut être un germe monocristallin ou multicristallin.

Dans un premier exemple de réalisation, le creuset est à base carrée par exemple de type 840x840mm². Le fond 2 du creuset est usiné de manière à former au moins une zone en dépression circulaire ayant un diamètre égale à 125mm. La profondeur de dépression est égale à 8mm. L'épaisseur des parois du creuset est de 20mm.

Les parois intérieures du creuset sont recouvertes par une couche anti-adhérente en nitrure de silicium afin d'éviter tout contact direct entre le silicium à cristalliser et le creuset 10 en silice. Les deuxièmes portions 2b sont dépourvues de couche anti-adhérente.

Un germe 3 monocristallin en silicium avec une orientation <100> est disposé dans chaque deuxième portion 2b.

Une charge de silicium de qualité solaire sensiblement égale à 400kg est déposée dans le creuset 10. La charge est fondue et en contact avec le germe 3 monocristallin. La solidification est initiée à partir du germe 3 monocristallin afin d'imposer l'orientation cristalline recherchée. Un ou plusieurs thermocouples sont disposés sous le creuset 10 afin de déterminer la position de la température de fusion du silicium dans le creuset par rapport au fond du creuset 10.

Classiquement, le gradient thermique à l'intérieur du creuset 10 est vertical, la température diminuant du haut du creuset 10 vers le fond 2. Ainsi, la solidification du matériau à l'intérieur du creuset 10 entraîne la formation de joints de grains perpendiculaires au fond du creuset 10. Cette configuration est avantageuse pour une utilisation dans des dispositifs photovoltaïques.

La régulation thermique au sein du creuset 10, est réalisée par tout moyen connu de façon à maintenir, stable et vertical, le gradient thermique au sein du creuset 10.

De manière préférentielle, le germe ou les germes ont une épaisseur comprise entre 5 et 25mm de manière à avoir une certaine marge de manoeuvre dans la fusion partielle du germe au début de la phase de solidification. De manière encore plus préférentielle, le germe a une épaisseur comprise entre 8 et 12mm afin de pouvoir l'intégrer dans une échancrure du creuset sans avoir trop d'impact sur les isothermes dans le creuset 10.

L'épaisseur du creuset 10 est préférentiellement comprise entre 12 et 40mm. Dans un mode de réalisation particulier, l'épaisseur du creuset est comprise entre 20 et 30mm. Plus le creuset est fin et plus l'extraction de chaleur est bonne, mais plus il est fragile. Cependant, dans cette gamme de température, il est possible de former un creuset avec une bonne différence de résistance thermique entre les différentes portions sans diminuer fortement la solidité du creuset. Dans un mode de réalisation encore plus particulier, l'épaisseur du creuset est comprise entre 20 et 22mm. Cette gamme a donné le meilleur compromis entre l'extraction thermique, la solidité du creuset et la différence de résistance thermique.

L'épaisseur du contre-creuset 5 est, préférentiellement, comprise entre 5 et 200mm de manière à avoir simultanément une bonne tenue mécanique et une résistance thermique modérée. Dans un mode de réalisation préférentiel, l'épaisseur du contre-creuset 5 est comprise entre 10 et 60mm lorsque ce dernier est en graphite. Augmenter l'épaisseur du contre-creuset permet d'augmenter sa résistance mécanique. Dans un autre mode de réalisation, l'épaisseur du contre-creuset 5 est comprise entre 10 et 30mm lorsque ce dernier est en composite carbone CFC.

## Revendications

1. Dispositif formant creuset pour la fabrication de matériau cristallin par cristallisation dirigée comportant un fond (2) et au moins une paroi latérale (4) dans lequel le fond (2) comporte :
- une première portion (2a) présentant une première résistance thermique et une deuxième portion (2b) présentant une deuxième résistance thermique inférieure à la première résistance thermique et destinée à recevoir un germe (3) en second matériau cristallin pour la fabrication dudit matériau cristallin,
le fond (2) et ladite au moins une paroi latérale (4) étant au moins en partie formés par une pièce étanche (1) comportant au moins une échancrure participant à définir lesdites premier et deuxième portions (2a, 2b),
dispositif **caractérisé en ce que** la première portion (2a) est recouverte par une première couche anti-adhérente (9,9a) ayant une première résistance thermique additionnelle et **en ce que** la deuxième portion (2b) est recouverte par une deuxième couche anti-adhérente (9b) ayant une deuxième résistance thermique additionnelle inférieure à la première résistance thermique ou la deuxième portion (2b) est dépourvue de couche anti-adhérente.

2. Dispositif selon la revendication 1, **caractérisé en ce que** la première couche anti-adhérente (9a) est plus épaisse que la seconde couche anti-adhérente (9b).

3. Dispositif selon l'une des revendications 1 et 2, **caractérisé en ce que** la première couche anti-adhérente (9a) est réalisée dans le même matériau que la seconde couche anti-adhérente (9b).

4. Dispositif selon l'une quelconques des revendications 1 à 3, **caractérisé en ce qu'**il comporte une pluralité de première et deuxième portions (2a, 2b) avec une alternance entre les première et seconde portions depuis une première face latérale (4) vers une seconde face latérale (4) opposée.

5. Dispositif selon l'une quelconque des revendications 1 à 4, **caractérisé en ce que** la paroi interne du fond (2) de la pièce étanche (1) comporte une échancrure représentative de la seconde portion (2b).

6. Dispositif selon l'une quelconque des revendications 1 à 4, **caractérisé en ce que** la paroi interne du fond (2) de la pièce étanche (1) est plane.

7. Dispositif selon l'une quelconque des revendications 1 à 5, **caractérisé en ce que** la paroi externe du fond (2) de la pièce étanche (1) comporte une échancrure représentative de la première portion (2a), et **en ce qu'**il comporte une pièce supplémentaire (8B) disposée dans ladite échancrure représentative de la première portion (2a), ladite pièce supplémentaire (8B) étant configurée pour que la somme de sa résistance thermique avec la résistance thermique de la pièce étanche (1) au niveau de la première portion (2a) est supérieure à la valeur de résistance thermique de la pièce étanche (1) au niveau de la seconde portion (2b).

8. Dispositif selon la revendication 7, **caractérisé en ce que** ladite pièce supplémentaire (8B) est réalisée en un matériau présentant une résistivité thermique supérieure à celle du fond de la pièce étanche (1).

9. Procédé de fabrication d'un creuset selon l'une quelconque des revendications 1 à 8 pour cristallisation dirigée comportant un fond (2) et au moins une paroi latérale (4) **caractérisé en ce qu'**il comporte :
- former un masque (11) sur le fond (2) du creuset (10) de manière à définir des zones recouvertes par le masque (11) et des zones découvertes,
- déposer un revêtement (12) destiné à former une couche anti-adhérente,
- éliminer le masque (11),
- recuire le revêtement (12) pour former la première couche anti-adhérente (9).

10. Procédé selon la revendication 9, **caractérisé en ce que** le masque (11) est une feuille de papier.

11. Procédé selon l'une des revendications 9 et 10, **caractérisé en ce que** le revêtement (12) est déposé par pulvérisation.

12. Procédé selon l'une quelconque des revendications 9 à 11, **caractérisé en ce que** le revêtement (12) est soumis à un recuit oxydant de manière à former une première couche anti-adhérente (9, 9a) oxydée en surface.

13. Procédé selon l'une quelconque des revendications 9 à 12, **caractérisé en ce qu'**il comporte le dépôt d'un revêtement additionnel sur la première portion (2a) et sur la deuxième portion (2b), le recuit formant la première couche anti-adhérente (9a) sur la première portion (2a) et la deuxième couche anti-adhérente (9b) sur la deuxième portion (2b).

14. Système de solidification de matériau cristallin comportant :
- un dispositif formant creuset (10) selon l'une quelconque des revendications 1 à 8,
- des moyens de génération d'un gradient thermique à l'intérieur du dispositif formant creuset (10) et
- un contre-creuset (5) réalisé dans un matériau présentant une résistivité thermique inférieure au matériau formant le fond (2) du dispositif formant creuset (10).

15. Système selon la revendication 14, **caractérisé en ce que** le contre-creuset (5) est disposé contre la face externe du fond (2) du dispositif formant creuset (10), le contre-creuset (5) présentant un fond avec une face interne ayant une forme complémentaire de la face externe du fond (2) du dispositif formant creuset (10).

16. Système selon l'une quelconque des revendications 14 et 15, **caractérisé en ce que** le fond du contre-creuset (5) a une épaisseur constante.

17. Système selon l'une quelconque des revendications 14 et 15, **caractérisé en ce que** la face externe du fond (2) du dispositif formant creuset (10) est plane.

18. Système selon l'une quelconque des revendications 14 à 17, **caractérisé en ce qu'**il comporte un extracteur de chaleur faisant face à la première (2a) et à la deuxième (2b) portion du fond (2) du dispositif formant creuset (10).

19. Système selon la revendication 14, **caractérisé en ce qu'**il comporte une résistance thermique additionnelle disposée entre le contre-creuset (5) et une dépression formée sur la face externe du fond (2) du dispositif formant creuset (10) de manière à assurer la conduction thermique de la zone en dépression avec le contre-creuset (5).

20. Procédé de fabrication d'un matériau cristallin par cristallisation dirigée d'un matériau en phase liquide dans un dispositif formant creuset (10) d'un système selon l'une quelconque des revendications 14 à 19, **caractérisé en ce qu'**il comporte :
- prévoir un dispositif formant creuset (10) selon l'une quelconque des revendications 1 à 8 muni d'un germe (3) en matériau cristallin disposé de manière à au moins partiellement recouvrir la seconde portion (2b) du fond du dispositif formant creuset (10), le dispositif formant creuset (10) étant au moins partiellement rempli par une charge de matériau à solidifier,
- générer un premier gradient thermique dans le dispositif formant creuset (10) de manière à faire fondre le matériau à solidifier, le germe (3) restant au moins partiellement à l'état solide,
- générer un second gradient thermique dans le dispositif formant creuset (10) de manière à solidifier le matériau à l'état fondu à partir du germe (3).

21. Procédé selon la revendication 20, **caractérisé en ce que** le germe est disposé dans une échancrure du fond (2) du dispositif formant creuset (1).

## Patentansprüche

1. Vorrichtung, die einen Schmelztiegel bildet, zur Herstellung eines kristallinen Materials durch gelenkte Kristallisation, welche einen Boden (2) und mindestens eine Seitenwand (4) umfasst, wobei der Boden (2) aufweist:
- einen ersten Abschnitt (2a) mit einem ersten spezifischen Wärmewiderstand und einen zweiten Abschnitt (2b) mit einem zweiten spezifischen Wärmewiderstand, welcher geringer ist als der erste spezifische Wärmewiderstand, der dazu bestimmt ist, einen Kristallkeim (3) aus einem zweiten kristallinen Material zur Herstellung des genannten kristallinen Materials aufzunehmen,
wobei der Boden (2) und die genannte mindestens eine Seitenwand (4) mindestens teilweise von einem dichten Teil (1) gebildet werden, das mindestens eine Aussparung aufweiset, die dazu beiträgt, die genannten ersten und zweiten Abschnitte (2a, 2b) zu bilden,
**dadurch gekennzeichnet,**
**dass** der erste Abschnitt (2a) mit einer ersten Antihaftschicht (9, 9a) beschichtet ist, die einen ersten zusätzlichen spezifischen Wärmewiderstand besitzt, und dass der zweite Abschnitt (2b) mit einer zweiten Antihaftschicht (9b) beschichtet ist, die einen zusätzlichen zweiten spezifischen Wärmewiderstand besitzt, welcher geringer ist als der erste spezifische Wärmewiderstand, oder dass der zweite Abschnitt (2b) nicht mit einer Antihaftschicht verstehen ist.

2. Vorrichtung nach Anspruch 1,
**dadurch gekennzeichnet,**
**dass** die erste Antihaftschicht (9a) dicker ist als die zweite Antihaftschicht (9b).

3. Vorrichtung nach einem der Ansprüche 1 und 2,
**dadurch gekennzeichnet,**
**dass** die erste Antihaftschicht (9a) aus dem gleichen Material hergestellt ist wie die zweite Antihaftschicht (9b).

4. Vorrichtung nach einem der Ansprüche 1 bis 3,
**dadurch gekennzeichnet,**
**dass** sie eine Vielzahl von ersten und zweiten Abschnitten (2a, 2b) in einer Wechselfolge der ersten und zweiten Abschnitte untereinander von einer ersten Seitenwand (4) zu einer zweiten, dieser gegenüber befindlichen Seitenwand (4) hin enthält.

5. Vorrichtung nach einem der Ansprüche 1 bis 4,
**dadurch gekennzeichnet,**
**dass** die Innenwand des Bodens (2) des dichten Teils (1) eine Aussparung enthält, die den zweiten Abschnitt (2b) darstellt.

6. Vorrichtung nach einem der Ansprüche 1 bis 4,
**dadurch gekennzeichnet,**
**dass** die Innenwand des Bodens (2) des dichten Teils (1) eben ist.

7. Vorrichtung nach einem der Ansprüche 1 bis 5,
**dadurch gekennzeichnet,**
**dass** die Außenwand des Bodens (2) des dichten Teils (1) eine Aussparung enthält, die den ersten Abschnitt (2a) darstellt, und dass sie ein zusätzliches Teil (8B) aufweist, das in dieser den ersten Abschnitt (2a) darstellenden Aussparung angeordnet ist, wobei dieses zusätzliche Teil (8B) dergestalt ausgeführt ist, dass die Summe von dessen spezifischen Wärmewiderstand mit dem spezifischen Wärmewiderstand des dichten Teils (1) im Bereich des ersten Abschnitts (2a) größer ist als der Wert des spezifischen Wärmewiderstandes des dichten Teils (1) im Bereich des zweiten Abschnitts (2b).

8. Vorrichtung nach Anspruch 7,
**dadurch gekennzeichnet,**
**dass** das genannte zusätzliche Teil (8B) aus einem Material hergestellt ist, das einen höheren spezifischen Wärmewiderstand als der des Bodens des dichten Teils (1) aufweist.

9. Verfahren zur Herstellung eines Schmelztiegels nach einem der Ansprüche 1 bis 8 zur gelenkten Kristallisation, der einen Boden (2) und mindestens eine Seitenwand (4) umfasst,
**dadurch gekennzeichnet,**
**dass** es darin besteht:
- eine Abdeckmaske (11) auf dem Boden (2) des Schmelztiegels (10) dergestalt zu bilden, dass Zonen, die von der Abdeckmaske (11) bedeckt sind, und Zonen, die nicht bedeckt sind, entstehen,
- eine Beschichtung (12) aufzutragen, die dazu vorgesehen ist, eine Antihaftschicht zu bilden,
- die Abdeckmaske (11) zu beseitigen,
- die Beschichtung (12) zu glühen, um die erste Antihaftschicht (9) zu bilden.

10. Verfahren nach Anspruch 9,
**dadurch gekennzeichnet,**
**dass** die Abdeckmaske (11) eine Papierfolie ist.

11. Verfahren nach einem der Ansprüche 9 und 10,
**dadurch gekennzeichnet,**
**dass** die Beschichtung (12) durch Zerstäuben aufgetragen wird.

12. Verfahren nach einem der Ansprüche 9 bis 11,
**dadurch gekennzeichnet,**
**dass** die Beschichtung (12) einem Oxidationsglühen unterzogen wird, so dass eine erste, an der Oberfläche oxidierte Antihaftschicht (9, 9a) gebildet wird.

13. Verfahren nach einem der Ansprüche 9 bis 12,
**dadurch gekennzeichnet,**
**dass** es das Auftragen einer zusätzlichen Beschichtung auf dem ersten Abschnitt (2a) und auf dem zweiten Abschnitt (2b) beinhaltet, wobei durch das Glühen die erste Antihaftschicht (9a) auf dem ersten Abschnitt (2a) und die zweite Antihaftschicht (9b) auf dem zweiten Abschnitt (2b) gebildet wird.

14. System zur Verfestigung von kristallinem Material, bestehend aus:
- einer einen Schmelztiegel (10) bildenden Vorrichtung nach einem der Ansprüche 1 bis 8,
- Mitteln zur Erzeugung eines Temperaturgradienten im Inneren der einen Schmelztiegel (10) bildenden Vorrichtung, und
- einem Gegen-Tiegel (5), der aus einem Material besteht, das einen geringeren spezifischen Wärmewiderstand besitzt als das Material, aus dem der Boden (2) der einen Schmelztiegel (10) bildenden Vorrichtung besteht.

15. System nach Anspruch 14,
**dadurch gekennzeichnet,**
**dass** der Gegen-Tiegel (5) an der Außenseite des Bodens (2) der einen Schmelztiegel (10) bildenden Vorrichtung angeordnet ist, wobei der Gegen-Tiegel (5) einen Boden hat, dessen Innenseite eine komplementäre Form zur Außenseite des Bodens (2) der einen Schmelztiegel (10) bildenden Vorrichtung aufweist.

16. System nach einem der Ansprüche 14 und 15,
**dadurch gekennzeichnet,**
**dass** der Boden des Gegen-Tiegels (5) eine konstante Dicke hat.

17. System nach einem der Ansprüche 14 und 15,
**dadurch gekennzeichnet,**
**dass** die Außenseite des Bodens (2) der einen Schmelztiegel (10) bildenden Vorrichtung eben ist.

18. System nach einem der Ansprüche 14 bis 17,
**dadurch gekennzeichnet,**
**dass** es einen Wärmeabsauger enthält, der sich gegenüber dem ersten Abschnitt (2a) und dem zweiten Abschnitt (2b) des Bodens (2) der einen Schmelztiegel (10) bildenden Vorrichtung befindet.

19. System nach Anspruch 14,
**dadurch gekennzeichnet,**
**dass** es einen zusätzlichen spezifischen Wärmewiderstand zwischen dem Gegen-Tiegel (5) und einer Vertiefung aufweist, die an der Außenseite des Bodens (2) der einen Schmelztiegel (10) bildenden Vorrichtung ausgeführt ist, so dass die Wärmeleitung der vertieften Zone mit dem Gegen-Tiegel (5) gewährleistet ist.

20. Verfahren zur Herstellung eines kristallinen Materials durch gelenkte Kristallisation eines Materials in Flüssigphase in einer einen Schmelztiegel (10) bildenden Vorrichtung eines Systems nach einem der Ansprüche 14 bis 19,
**dadurch gekennzeichnet,**
**dass** es darin besteht:
- eine einen Schmelztiegel (10) bildende Vorrichtung nach einem der Ansprüche 1 bis 8 vorzugehen, welche mit einem Kristallkeim (3) aus kristallinem Material bestückt wird, der dergestalt angeordnet wird, dass er zumindest teilweise den zweiten Abschnitt (2b) des Bodens der einen Schmelztiegel (10) bildenden Vorrichtung bedeckt, wobei die einen Schmelztiegel (10) bildende Vorrichtung zumindest teilweise mit einer Ladung an zu verfestigendem Material befüllt ist,
- in der einen Schmelztiegel (10) bildenden Vorrichtung einen Temperaturgradient dergestalt zu erzeugen, dass das zu verfestigende Material geschmolzen wird, wobei der Kristallkeim (3) zumindest teilweise in festem Zustand bleibt,
- in der einen Schmelztiegel (10) bildenden Vorrichtung einen zweiten Temperaturgradient dergestalt zu erzeugen, dass das geschmolzene Material von dem Kristallkeim (3) ausgehend verfestigt wird.

21. Verfahren nach Anspruch 20,
**dadurch gekennzeichnet,**
**dass** der Kristallkeim in einer Aussparung im Boden (2) der einen Schmelztiegel bildenden Vorrichtung (1) angeordnet wird.

## Claims

1. A device forming crucible for fabrication of crystalline material by directional solidification comprising a bottom (2) and at least one side wall (4) wherein the bottom (2) comprises:
- a first portion (2a) presenting a first thermal resistance and a second portion (2b) presenting a second thermal resistance that is lower than the first thermal resistance and designed to receive a seed (3) made from second crystalline material for fabrication of said crystalline material,
the bottom (2) and said at least one side wall (4) being at least partly formed by a tightly sealed part (1) comprising at least one indentation participating in defining said first and second portions (2a, 2b),
device **characterized in that** the first portion (2a) is covered by a first anti-adherent layer (9,9a) having an additional first thermal resistance and **in that** the second portion (2b) is covered by a second anti-adherent layer (9b) having an additional second thermal resistance that is lower than the first thermal resistance or the second portion (2b) is devoid of anti-adherent layer.

2. The device according to claim 1, **characterized in that** the first anti-adherent layer (9a) is thicker than the second anti-adherent layer (9b).

3. The device according to one of claims 1 and 2, **characterized in that** the first anti-adherent layer (9a) is made from the same material as the second anti-adherent layer (9b).

4. The device according to any one of claims 1 to 3, **characterized in that** it comprises a plurality of first and second portions (2a, 2b) with an alternation between the first and second portions from a first side wall (4) to an opposite second side wall (4).

5. The device according to any one of claims 1 to 4, **characterized in that** the inner wall of the bottom (2) of the tightly sealed part (1) comprises an indentation representative of the second portion (2b).

6. The device according to any one of claims 1 to 4, **characterized in that** the inner wall of the bottom (2) of the tightly sealed part (1) is flat.

7. The device according to any one of claims 1 to 5, **characterized in that** the outer wall of the bottom (2) of the tightly sealed part (1) comprises an indentation representative of the first portion (2a), and **in that** it comprises an additional part (8B) located in said indentation representative of the first portion (2a), said additional part (8B) being configured so that the sum of its thermal resistance with the thermal resistance of the tightly sealed part (1) at the level of the first portion (2a) is greater than the thermal resistance value of the tightly sealed part (1) at the level of the second portion (2b).

8. The device according to claim 7, **characterized in that** said additional part (8B) is made from a material presenting a higher thermal resistivity than that of the bottom of the tightly sealed part (1).

9. A method for fabrication of a crucible according to any one of claims 1 to 8 for directional solidification comprising a bottom (2) and at least one side wall (4) **characterized in that** it comprises:
- forming a mask (11) on the bottom (2) of the crucible (10) so as to define areas covered by the mask (11) and uncovered areas,
- depositing a coating (12) designed to form an anti-adherent layer,
- eliminating the mask (11),
- annealing the coating (12) to form the first anti-adherent layer (9).

10. The method according to claim 9, **characterized in that** the mask (11) is a sheet of paper.

11. The method according to one of claims 9 and 10, **characterized in that** the coating (12) is deposited by spraying.

12. The method according to any one of claims 9 to 11, **characterized in that** the coating (12) is subjected to an oxidizing annealing so as to form a first anti-adherent layer (9, 9a) oxidized on the surface.

13. The method according to any one of claims 9 to 12, **characterized in that** it comprises deposition of an additional coating on the first portion (2a) and the second portion (2b), the annealing forming the first anti-adherent layer (9a) on the first portion (2a) and the second anti-adherent layer (9b) on the second portion (2b).

14. A system for solidification of crystalline material comprising:
- a device forming crucible (10) according to any one of claims 1 to 8,
- means for generating a thermal gradient inside the device forming crucible (10) and
- a counter-crucible (5) made from a material presenting a lower thermal resistivity than the material forming the bottom (2) of the device forming crucible (10).

15. The system according to claim 14, **characterized in that** the counter-crucible (5) is located against the outer surface of the bottom (2) of the device forming crucible (10), the counter-crucible (5) presenting a bottom with an inner surface having a complementary shape to the outer surface of the bottom (2) of the device forming crucible (10).

16. The system according to any one of claims 14 and 15, **characterized in that** the bottom of the counter-crucible (5) has a constant thickness.

17. The system according to any one of claims 14 and 15, **characterized in that** the outer surface of the bottom (2) of the device forming crucible (10) is flat.

18. The system according to any one of claims 14 to 17, **characterized in that** it comprises a heat extractor facing the first portion (2a) and the second portion (2b) of the bottom (2) of the device forming crucible (10).

19. The system according to claim 14, **characterized in that** it comprises an additional thermal resistance arranged between the counter-crucible (5) and a recess formed on the outer surface of the bottom (2) of the device forming crucible (10) so as to perform thermal conduction of the recessed area with the counter-crucible (5).

20. A method for fabrication of a crystalline material by directional solidification of a material in liquid phase in a device forming crucible (10) of a system according to any one of claims 14 to 19, **characterized in that** it comprises:
- providing a device forming crucible (10) according to any one of claims 1 to 8 provided with a seed (3) made from crystalline material arranged in such a way as to at least partially cover the second portion (2b) of the bottom of the device forming crucible (10), the device forming crucible (10) being at least partially filled by a feedstock of material to be solidified,
- generating a first thermal gradient in the device forming crucible (10) so as to melt the material to be solidified, the seed (3) remaining at least partially in solid state,
- generating a second thermal gradient in the device forming crucible (10) so as to solidify the material in the molten state from the seed (3).

21. The method according to claim 20, **characterized in that** the seed is arranged in an indentation of the bottom (2) of the device forming crucible (1).
